# EUROPEAN PATENT APPLICATION

(11) **EP 0 589 817 A1**
(43) Date of publication of application: **30.03.1994**
(21) Application number: 93500077.8
(22) Date of filing: 08.06.1993
(51) Int. Cl.: G01R 11/24

(54) **Antifraud device in electronic electricity meters**

(30) Priority: 25.09.1992 ES 9201909
(71) Applicant: AMPER TELEMATICA, S.A., 28027 Madrid (ES)
(72) Inventor: Pecharroman Teruel, José, AMPER TELEMATICA, Km12.700, Fundidores s/n, E-28906 Getafe (ES); Tarrafeta Montoya, José Maria, AMPER TELEMATICA, Km12.700, Fundidores s/n, E-28906 Getafe (ES)
(74) Representative: Carpintero Lopez, Francisco

(57) **Abstract**

The antifraud device in electronic electricity meters subject of the invention, the purpose of which is to detect a possible deception due to manipulations in the meter connections to the electricity mains, advantageously resolves the most widespread kind of fraud, viz. disconnection of the potential coil (5) of the meter (1). To this end, the device basically comprises a Hall sensor (4) associated to the measurement coil(s) and connected to the rotation sensor (6) of the induction disc (7) in the meter (1), the necessary means being further provided for the supply of the data fed by the Hall sensor (4) as to the status of the potential coil (5).

## Description

### OBJECT OF THE INVENTION

The present invention relates, as set forth in the heading to this specification, to an antifraud device in electronic electricity meters, the purpose of which is to detect manipulations in meter connections to the electricity mains.

### BACKGROUND OF THE INVENTION

In the electronic measurement of watts-hour, VARs-hour and so forth using conventional induction meters of the kind provided with an electronic circuit feeding digital data for computation, centralisation, telemetering and so forth, it is necessary to establish means to detect a possible fraud due to a manipulation of the meter connections.

Induction meters basically work with a disc turning by action of two electromagnetic fields generated in the potential and current coils. The most common deceptive method is disconnection of the potential coil, preventing the power torque in the induction disc from being generated. In this way, consumptions are neither totalled in the mechanical integrator of the meter nor are computation signals made in the digital connection. It is therefore necessary to incorporate a specific circuitry supervising correct connection of the meter coils in order to ensure a reliable reading.

Some solutions imply direct connection to the electricity mains, monitoring voltage, but are inconvenient in that these circuits must be protected from strong overvoltages which might be present from time to time in electricity mains (lightning and so forth) and that meters must also withstand undamaged. The protective elements lead to a notable increase in the cost of these circuits and also reduce the useful life of the equipment or require maintenance tasks unacceptable in this kind of applications.

### DESCRIPTION OF THE INVENTION

The antifraud device in electronic electricity meters subject of the invention fully solves the above problems by fitting the meter with a Hall sensor to detect the magnetic field generated by the potential coil, so that since there is no electric connection to the mains the circuit is immune to overvoltages present in the mains and is therefore advantageous in providing galvanic insulation between the electricity mains and the metering device.

To avoid the effects of the surplus field in the magnetic circuit, the Hall sensor must be bipolar so as to provide a digital signal in the mains frequency while the coil is being fed and will remain stable in the event of fraud or energy cut-off. If these two conditions need to be distinguished, it is necessary to include a second sensor in the current coil which shall have to be very sensitive if small consumptions are to be detected.

The electronic circuits added to the meters usually provide a digital output for an external unit to make a summation of consumptions, concentration of measurements of several meters, communication tasks for remote reading, and so forth. This digital connection shall contain data as to speed of rotation of the disc and frequently on the direction of rotation. In accordance with the present invention it shall also incorporate data on the status of the potential coil (fed or otherwise) in order to be able to detect a possible fault, cut-off or manipulation of the meter connection.

### DESCRIPTION OF THE DRAWINGS

In order to provide a fuller description and contribute to the complete understanding of the characteristics of this invention, a set of drawings is attached to the specification which, while purely illustrative and not fully comprehensive, shows the following:

Figure 1.- Shows a conventional induction meter and connection thereof of the electricity mains.

Figure 2.- Shows a connection of the circuit within the meter, including a Hall sensor.

Figure 3.- Is a diagram showing how the invention is applied, using a circuit sensing rotation with control input.

### PREFERRED EMBODIMENT OF THE INVENTION

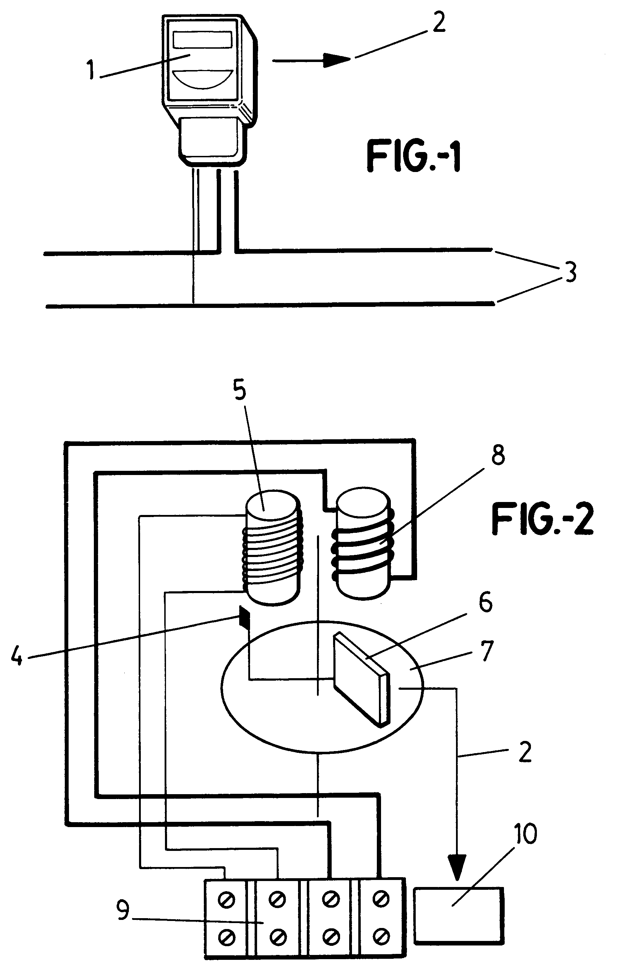

In light of the drawings it is clear that the antifraud device in electronic electricity meters subject hereof basically comprises using a conventional meter (1) in which a device is included to generate digital data (2) allowing the electronic computation or telemetering tasks to be carried out. Connection thereof to the electricity mains (2) takes place in accordance with the diagram shown in figure 1.

The arrangement of the Hall sensor (4), shown in figure 2, is such that it is able to detect the magnetic field created by the potential coil (5) and joined to a circuit sensing rotation (6) located close to the induction disc (7) to detect its speed by any of the usual methods. Other elements shown in figure 2 are the current coil (8) of the meter (1), a connecting strip (9) for the mains (3) and an element (10) to process the digital data (2).

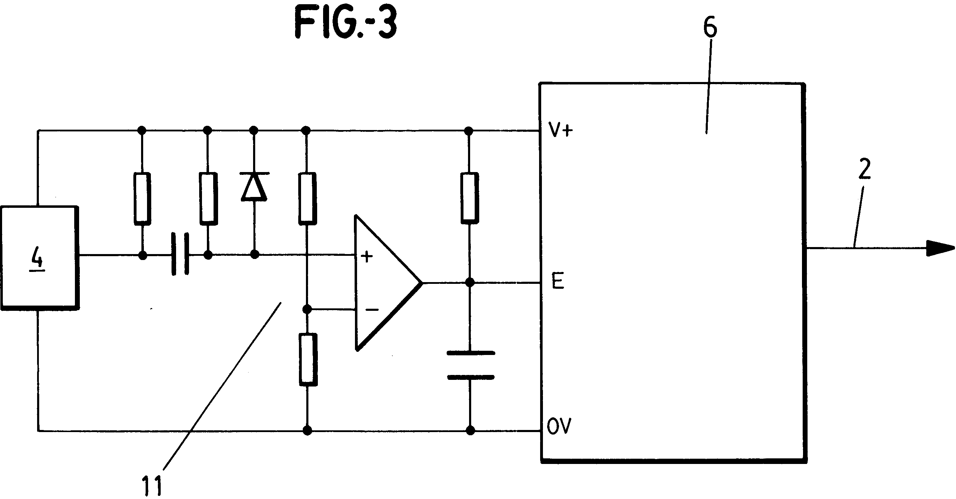

A specific application based on the use of a rotation sensor with control input (E) is shown in figure 3. The Hall sensor (4) generates a low or high level, depending on the polarity of the magnetic field. The following networks (11) detect the activity at the Hall sensor (4) output and control the input (E) to enable/disable the rotation sensor (6) so that when there is activity in the Hall sensor (4) a low level is applied at the control input, allowing the system to operate.

In the above embodiment the sensing circuit (6) detects disc (7) rotation and generates two pulse outputs. The Hall sensor (4) allows the circuit to work properly while the potential coil (5) is being fed and prompts a situation of alertness when the magnetic field disappears.

## Claims

**1.-** Antifraud device in electronic electricity meters, the purpose of which being to detect a possible deception due to manipulations in the meter connections to the electricity mains, essentially characterised in comprising a Hall sensor (4) associated to the measurement, potential (4) and as appropriate current (8), coil(s) and connected to the rotation sensor (6) of the induction disc (7) in the meter (1), the necessary means being provided for the supply of the data fed by the Hall sensor (4) as to the status of the potential coil (5).

**2.-** Antifraud device in electronic electricity meters.
